Europäisches Patentamt

European Patent Office

Office européen des brevets

(19)

(11) Veröffentlichungsnummer: **0 358 924**

**A1**

## (12) EUROPÄISCHE PATENTANMELDUNG

(21) Anmeldenummer: **89114341.4**

(22) Anmeldetag: **03.08.89**

(51) Int. Cl.⁵: **H03K 17/08 , H02H 11/00**

(30) Priorität: **16.08.88 DE 3827730**

(43) Veröffentlichungstag der Anmeldung:
**21.03.90 Patentblatt 90/12**

(84) Benannte Vertragsstaaten:
**DE ES FR GB IT SE**

(71) Anmelder: **Hella KG Hueck & Co.**
**Rixbecker Strasse 75 Postfach 28 40**
**D-4780 Lippstadt(DE)**

(72) Erfinder: **Eickel, Franz-Josef**
**Nettelstädt 43**
**D-4784 Rüthen(DE)**
Erfinder: **Thiemann, Hans-Joachim**
**Neuhäuser Strasse 110 a**
**D-4790 Paderborn(DE)**
Erfinder: **Herlt, Rainer**
**Gisbert-Cremer-Strasse 9**
**D-5090 Leverkusen 1(DE)**

(54) **Steuergerät mit einer Schaltungsanordnung zum Schutz des Steuergeräts bei Unterbrechung der Steuergerätemasse.**

(57) Bei einem Steuergerät mit einer Schaltungsanordnung zum Schutz des Steuergeräts bei Unterbrechung der Steuergerätemasse (SM), insbesondere in Kraftfahrzeugen, mit einem MOS-Feldeffekttransistor (T1) in einem Ausgangskreis mit einem Steuereingang (E), der mit der Gate-Elektrode des MOS-Feldeffekttransistors verbunden ist, um diesen in den leitenden oder sperrenden Zustand zu schalten, und mit einem bipolaren Transistor (T2), der dem MOS-Feldeffekttransistor zum Schutz zugeordnet ist, ist zur Vermeidung einer undefinierten Ansteuerung des MOS-Feldeffekttransistors und einer Zerstörung von Bauteilen des Steuergeräts mindestens eine Last (L) zwischen dem negativen Pol einer Spannungsquelle (B) und der Source-Elektrode angeordnet, die über die Drain-Elektrode mit dem positiven Pol der Spannungsquelle elektrisch leitend verbindbar ist und ein zweiter Widerstand (R2) zum einen über einen Verbindungspunkt (V) mit dem ersten Widerstand (R1) und mit der Steuergerätemasse (SM) und zum anderen mit der Basis des bipolaren Transistors (T2) verbunden.

EP 0 358 924 A1

## Steuergerät mit einer Schaltungsanordnung zum Schutz des Steuergeräts bei Unterbrechung der Steuergerätemasse

Die Erfindung betrifft ein Steuergerät mit einer Schaltungsanordnung zum Schutz des Steuergeräts bei Unterbrechung der Steuergerätemasse, insbesondere in Kraftfahrzeugen, mit einem MOS-Feldeffekttransistor in einem Ausgangskreis, mit einem Steuereingang, der mit der Gate-Elektrode des MOS-Feldeffekttransistors verbunden ist, um diesen in den leitenden oder sperrenden Zustand zu schalten, und mit einem bipolaren Transistor, dessen Kollektor mit der Gate-Elektrode, dessen Emitter mit der Source-Elektrode und dessen Basis über einen ersten Widerstand mit der Drain-Elektrode des MOS-Feldeffekttransistors verbunden ist.

Aus der deutschen Patentschrift DE-PS 35 00 039 ist eine Schaltungsanordnung zum Schutz eines MOS-Feldeffekttransistors gegen Stromüberlastung bekannt.

Diese Schaltungsanordnung weist einen Ausgangskreis auf, in dem die Drain-Elektrode über eine Last mit dem positiven Pol der Spannungsquelle verbunden ist und die Source-Elektrode mit dem negativen Pol der Spannungsquelle verbunden ist. Um den MOS-Feldeffekttransistor in den leitenden oder sperrenden Zustand zu schalten, ist eine Vorspannungseinrichtung vorgesehen, die mit der Gate-Elektrode und der Source-Elektrode verbunden ist. Zur Überwachung des in dem Ausgangskreis fließenden Stroms ist die Drain-Elektrode über einen Widerstand mit der Basis eines bipolaren Transistors verbunden. Der Kollektor des bipolaren Transistors ist mit der Gate-Elektrode und der Emitter des bipolaren Transistors ist mit der Source-Elektrode des MOS-Feldeffekttransistors verbunden.

Tritt in dem Ausgangskreis eine Stromüberlastung auf, die z. B. durch einen Fehler in der Last hervorgerufen werden kann, so daß die Basis-Emitter-Einschaltspannung des bipolaren Transistors überschritten wird, wird der bipolare Transistor stromleitend. Die Gate-Elektrode wird somit auf das Potential der Source-Elektrode gesetzt, wodurch der MOS-Feldeffekttransistor gesperrt wird und so vor einer Zerstörung durch einen zu hohen Strom geschützt wird. Die Abschaltung ist dabei regenerativ, so daß bei einem Wegfall des Fehlers der MOS-Feldeffekttransistor wieder leitend geschaltet wird.

Ist diese Schaltungsanordnung Teil eines Steuergeräts, das eine eigene Steuergerätemasse aufweist, so kann es bei einer Unterbrechung der Steuergerätemasse, z. B. durch ein Abziehen oder Abgleiten der Stecker des Steuergeräts oder durch einen Kabelbruch, zu Fehlfunktionen des Steuergeräts und einer undefinierten Ansteuerung des MOS-Feldeffekttransistors kommen, die eine Zerstörung von Bauteilen des Steuergeräts zur Folge haben kann, wenn in diesem Fall der MOS-Feldeffekttransistor nicht abgeschaltet wird.

Der Erfindung liegt daher die Aufgabe zugrunde, ein Steuergerät zu schaffen, bei dem auf einfache und kostengünstige Art und Weise eine undefinierte Ansteuerung eines MOS-Feldeffekttransistors und eine Zerstörung von Bauteilen des Steuergeräts vermieden wird, wenn die Steuergerätemasse unterbrochen wird oder auf ein positives Potential gelegt wird.

Die Aufgabe wird dadurch gelöst, daß mindestens eine Last zwischen dem negativen Pol einer Spannungsquelle und der Source-Elektrode angeordnet ist, die über die Drain-Elektrode mit dem positiven Pol der Spannungsquelle elektrisch leitend verbindbar ist und daß ein zweiter Widerstand zum einen über einen Verbindungspunkt mit dem ersten Widerstand und mit der Steuergerätemasse und zum anderen mit der Basis des bipolaren Transistors verbunden ist.

Dadurch, daß mindestens eine Last zwischen dem negativen Pol einer Spannungsquelle und der Source-Elektrode angeordnet ist, die über die Drain-Elektrode mit dem positiven Pol der Spannungsquelle elektrisch leitend verbindbar ist, ergibt sich der Vorteil, daß das Steuergerät einfach und kostengünstig herstellbar ist und daß die Lasten zentral über das Steuergerät mit dem positiven Pol der Spannungsquelle verbunden werden und an dem Ort ihrer Anbringung lediglich mit dem negativen Pol der Spannungsquelle verbunden werden müssen.

Es ist von Vorteil, daß ein zweiter Widerstand zum einen über einen Verbindungspunkt mit dem ersten Widerstand und mit der Steuergerätemasse und zum anderen mit der Basis des bipolaren Transistors verbunden ist, weil somit bei einer Unterbrechung der Steuergerätemasse, die z. B. durch ein Abziehen der Stecker oder einen Kabelbruch erfolgen kann, der MOS-Feldeffekttransistor über den bipolaren Transistor in den sperrenden Zustand geschaltet wird, wodurch eine undefinierte Ansteuerung des MOS-Feldeffekttransistors und eine Zerstörung von Bauteilen des Steuergeräts vermieden wird, die bei einer fehlenden Steuergerätemasse nicht auszuschließen ist.

Weitere vorteilhafte Ausgestaltungen und Weiterbildungen des Erfindungsgegenstands gehen aus den Unteransprüchen hervor.

Insbesondere ist es vorteilhaft, daß die Anode einer ersten Zenerdiode mit der Source-Elektrode des MOS-Feldeffekttransistors und die Kathode der ersten Zenerdiode mit der Basis des bipolaren Transistors verbunden ist, weil somit die Emitter-Basis-Sperrspannung des bipolaren Transistors auf einen vorgegebenen Wert begrenzt wird und bei auftretenden Störspannungen, die z. B von der Last oder dem Steuereingang kommen, vermieden wird, daß der bipolare Transistor leitend geschaltet wird und somit den MOS-Feldeffekttransistor in den sperrenden Zustand schaltet oder Fehlfunktionen verursacht.

Es ist von Vorteil, daß die Anode einer zweiten Zenerdiode mit der Source-Elektrode und die Kathode der zweiten Zenerdiode mit der Gate-Elektrode des MOS-Feldeffekttransistors verbunden ist, weil so auf einfache und kostengünstige Weise die Spannung zwischen der Gate-Elektrode und der Source-Elektrode auf einen vorgegebenen Wert begrenzt wird und gleichzeitig eine Begrenzung des Stroms erfolgt, wodurch eine Zerstörung des MOS-Feldeffekttransistors vermieden wird und die Sicherheit bei dem Betrieb des Steuergeräts erhöht wird.

In diesem Zusammenhang ist es von Vorteil, daß die Source-Elektrode über einen dritten Widerstand mit der Gate-Elektrode des MOS-Feldeffekttransistors verbunden ist, wodurch ebenfalls ein Schutz des MOS-Feldeffekttransistors erreicht wird und Fehlfunktionen bei möglichen vorliegenden Störspannungen verhindert oder vermindert werden. Es ist von Vorteil, daß die Drain-Elektrode über eine bidirektionale Doppel-Zenerdiode mit der Source-Elektrode des MOS-Feldeffekttransistors verbunden ist, weil so auf einfache und kostengünstige Weise der MOS-Feldeffekttransistor vor Überspannungen in dem Ausgangskreis des Steuergeräts geschützt wird.

Dadurch, daß die Drain-Elektrode und der positive Pol der Spannungsquelle über einen Kondensator mit dem negativen Pol der Spannungsquelle verbunden ist, ergibt sich der Vorteil, daß von der Spannungsquelle dem Steuergerät zugeführte Störungen in der Spannung unterdrückt werden.

Besonders vorteilhaft ist, daß die Steuergerätemasse über einen externen Schalter oder eine externe Schaltvorrichtung auf ein positives Potential oder potentialfrei schaltbar ist, weil somit das Steuergerät auf einfache und kostengünstige Weise manuell oder in Abhängigkeit von externen Steuergrößen abschaltbar ist, wodurch die Sicherheit bei dem Betrieb des Geräts erhöht wird.

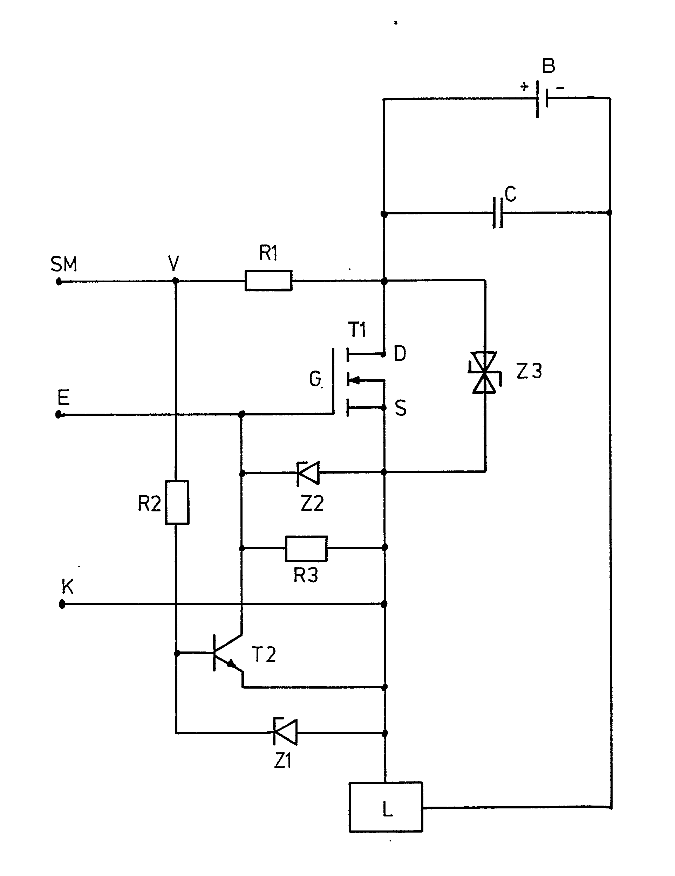

Ein Ausführungsbeispiel des Erfindungsgegenstands ist in der Zeichnung dargestellt und wird im folgenden anhand der Zeichnung näher beschrieben.

Die einzige Zeichnung zeigt eine Schaltungsanordnung zum Schutz des Steuergeräts bei Unterbrechung der Steuergerätemasse.

Die Schaltungseinrichtung weist einen Ausgangskreis auf, der mit einer Spannungsquelle (B) verbunden ist. Der positive Pol der Spannungsquelle (B) ist mit der Drain-Elektrode (D) eines MOS-Feldeffekttransistors (T1) verbunden. Die Source-Elektrode (S) des MOS-Feldeffekttransistors (T1) ist elektrisch leitend mit einer Last (L) verbunden. Bei einem anderen Ausführungsbeispiel kann die Source-Elektrode (S) auch mit mehreren Lasten (L) verbunden sein. Die Last (L) ist zudem elektrisch leitend mit dem negativen Pol der Spannungsquelle (B) verbunden.

Um die Last (L) mit dem positiven Pol der Spannungsquelle (B) in Verbindung zu setzen, verfügt die erfindungsgemäße Schaltungsanordnung über einen Steuereingang (E), der mit der Gate-Elektrode (G) des MOS-Feldeffekttransistors (T1) verbunden ist. Durch das Anlegen einer vorgegebenen Spannung an dem Steuereingang (E) wird der MOS-Feldeffekttransistor (T1) in den leitenden oder sperrenden Zustand geschaltet und somit die Last (L) mit dem positiven Pol der Spannungsquelle (B) verbunden oder von dem positiven Pol der Spannungsquelle (B) getrennt. Die an dem Steuereingang (E) anliegende Spannung kann dabei auch ein vorgegebenes veränderliches Puls-Periodenverhältnis aufweisen, um die Last (L) entsprechend diesem Puls-Periodenverhältnis getaktet ansteuern zu können. Bei einem anderen Ausführungsbeispiel des Erfindungsgegenstands ist eine Klemme (K) elektrisch leitend mit der Source-Elektrode (S) und der Last (L) verbunden. Über diese Klemme (K) ist dem Ausgangskreis eine Spannung entnehmbar, die zur Kontrolle und/oder Überwachung des Ausgangskreises und/oder des Stroms, der in dem Ausgangskreis fließt, verwendet werden kann. Ein anderes Ausführungsbeispiel ergibt sich, wenn die Ansteuerung der Gate-Elektrode (G) mittels einer Bootstrap-Methode erfolgt, bei der über die Klemme (K), einem Kondensator und einem Widerstand, die hier nicht gezeigt werden, dem Steuereingang (E) zur Rückkopplung und damit für eine exaktere Ansteuerung eine Spannung zuführt, die dem Strom, der in dem Ausgangskreis fließt, entspricht.

Zum Schutz des Steuergeräts weist die erfindungsgemäße Schaltungsanordnung einen bipolaren Transistor (T2) auf, dessen Kollektor elektrisch leitend mit der Gate-Elektrode (G) des MOS-Feldeffekttransistors (T1) verbunden ist. Der Emitter des bipolaren Transistors (T2) ist elektrisch leitend mit der Source-Elektrode (S) des MOS-Feldeffekttransistors (T1) verbunden. Die Basis des bipolaren Transistors (T2) ist elektrisch leitend über einen zweiten Widerstand (R2) und einen ersten Widerstand (R1) mit der Drain-Elektrode (D) des MOS-Feldeffekttransistors (T1) verbunden. Um den bipolaren Transistor (T2) in dem sperrenden Zustand zu schalten, ist der Verbindungspunkt (V) zwischen dem ersten Widerstand (R1) und dem zweiten Widerstand (R2) mit der Steuergerätemasse (SM) elektrisch leitend verbunden.

Um die Emitter-Basis-Sperrspannung des bipolaren Transistors (T2) auf einen vorgegebenen Wert zu begrenzen und zu vermeiden, daß bei von der Last (L) oder dem Steuereingang (E) anliegenden kurzzeitigen Störspannungen der bipolare Transistor (T2) leitend geschaltet wird und somit der MOS-Feldeffekttransistor (T1) in den sperrenden Zustand geschaltet wird, ist die Anode einer ersten Zenerdiode (Z1) mit der Source-Elektrode (S) und die Kathode der ersten Zenerdiode (Z1) mit der Basis des bipolaren Transistors (T2) elektrisch leitend verbunden.

Bei einem anderen Ausführungsbeispiel des Erfindungsgegenstands kann die erste Zenerdiode (Z1) durch eine Gleichrichterdiode und einem parallel zu der Gleichrichterdiode angeordneten Kondensator ersetzt sein.

Um die Spannung zwischen der Gate-Elektrode (G) und der Source-Elektrode (S) des MOS-Feldeffekttransistors (T1) auf einen vorgegebenen Wert zu begrenzen und zusätzlich eine Strombegrenzung zu erreichen, ist die Anode einer zweiten Zenerdiode (Z2) elektrisch leitend mit der Source-Elektrode (S) verbunden und ist die Kathode der zweiten Zenerdiode (Z2) elektrisch leitend mit der Gate-Elektrode (G) verbunden. Zusätzlich kann die Source-Elektrode (S) elektrisch leitend über einen dritten Widerstand (R3) mit der Gate-Elektrode (G) verbunden sein, um einen Schutz bei einer undefinierten Ansteuerung der Gate-Elektrode (G) zu erreichen und Fehlfunktionen bei möglichen vorliegenden Störspannungen zu verhindern oder zu vermeiden.

Zum Schutz des MOS-Feldeffekttransistors (T1) gegen Störspannungen und insbesondere gegen Überspannungen in dem Ausgangskreis des Steuergeräts ist die Drain-Elektrode (D) elektrisch leitend über eine bidirektional wirkende Doppel-Zenerdiode (Z3) mit der Source-Elektrode (S) des MOS-Feldeffekttransistors (T1) verbunden.

Um Störspannungen von der Spannungsquelle (B) in dem Ausgangskreis zu unterdrücken, ist der positive Pol der Spannungsquelle (B) und die Drain-Elektrode (D) des MOS-Feldeffekttransistors über einen Kondensator (C) mit dem negativen Pol der Spannungsquelle (B) verbunden.

Im folgenden wird kurz ein Anwendungsbeispiel des Erfindungsgegenstands beschrieben.

Um die Last (L) ein- und ausschalten zu können. d. h. mit dem positiven Pol der Spannungsquelle (B) in Verbindung zu bringen oder von ihr zu trennen, wird an dem Steuereingang (E) eine vorgegebene Spannung angelegt, die den MOS-Feldeffekttransistor (T1) in den leitenden oder sperrenden Zustand schaltet. Um die Last (L), die z. B. als ein Gleichstrommotor oder eine Lampe ausgebildet sein kann, mit einer geringeren Leistung betreiben zu können als die Nennleistung der Last (L), kann an dem Steuereingang (E) eine Spannung angelegt werden, die ein vorgegebenes veränderliches Puls-Periodenverhältnis aufweist, so daß der MOS-Feldeffekttransistor (T1) entsprechend diesem Puls-Periodenverhältnis in den leitenden und sperrenden Zustand geschaltet wird und somit die Last (L) getaktet angesteuert wird.

Das Steuergerät verfügt über eine eigene Steuergerätemasse (SM), die dem Steuergerät über eine Steckverbindung zugeführt werden.

Die Basis des bipolaren Transistors (T2) ist über den zweiten Widerstand (R2) und den Verbindungspunkt (V) mit dieser Steuergerätemasse (SM) elektrisch leitend verbunden. Die Emitter-Kollektorstrecke des bipolaren Transistors (T2) wird somit in den nichtleitenden Zustand geschaltet.

Bei einer Unterbrechung der Steuergerätemasse (SM), die z. B. durch ein Abziehen oder Abgleiten der Steckverbindung des Steuergeräts während des Betriebs erfolgen kann oder aber auch durch einen Kabelbruch außerhalb oder innerhalb des Geräts erfolgen kann, wird die Basis des bipolaren Transistors (T2) über den zweiten Widerstand (R2), den Verbindungspunkt (V) und den ersten Widerstand (R1) auf ein positives Potential gesetzt, das von der Größe des ersten und des zweiten Widerstands (R1, R2) abhängt und veränderlich ist. Durch dieses positive Potential an der Basis des bipolaren Transistors (T2) wird dieser über die Emitter-Kollektorstrecke in den leitenden Zustand geschaltet, so daß die Gate-Elektrode (G) des MOS-Feldeffekttransistors (T1) mit der Source-Elektrode (S) des MOS-Feldeffekttransistors (T1) elektrisch leitend verbunden wird. Die Gate-Elektrode (G) wird somit auf das Potential der Source-Elektrode (S) gesetzt, wodurch der MOS-Feldeffekttransistor (T1) in den sperrenden Zustand geschaltet wird und die Steuergerätefunktion abgeschaltet wird.

Damit wird vermieden, daß bei einer Unterbrechung der Steuergerätemasse (SM) des Steuergeräts, oder bei einem positiven Potential an der Steuergerätemasse (SM), wodurch an dem Steuereingang (E) von einer hier nicht gezeigten Ansteuerelektronik des Steuergeräts Spannungen anliegen können, der MOS-Feldeffekttransistor (T1) undefiniert angesteuert wird.

Durch dieses Abschalten des MOS-Feldeffekttransistors (T1) und damit der Steuergerätefunktion bei einer Unterbrechung der Steuergerätemasse (SM) oder bei einem positiven Potential an der Steuergerätemasse (SM) wird vermieden, daß der MOS-Feldeffekttransistor (T1) und damit die Last (L) undefiniert angesteuert wird, wodurch die Sicherheit bei dem Betrieb des Steuergeräts erhöht wird, und daß Bauteile der erfindungsgemäßen Schaltungsanordnung, insbesondere der MOS-Feldeffekttransistor (T1) oder aber Bauteile der hier nicht gezeigten mit dem Steuereingang (E) verbundenen Ansteuerelektronik zerstört werden.

Bei einem anderen Ausführungsbeispiel kann die Steuergerätemasse (SM) über einen außerhalb des Steuergeräts liegenden Schalter oder eine Schalteinrichtung mit einem positiven Potential verbindbar oder potentialfrei schaltbar sein, wodurch manuell oder in Abhängigkeit von bestimmten Steuergrößen, die z. B. die Spannung von einem Öldruckschalter sein kann, der MOS-Feldeffekttransistor (T1) über den bipolaren Transistor (T2) in den sperrenden Zustand geschaltet werden kann und somit die Steuergerätefunktion ohne einen zusätzlichen Funktionseingang abgeschaltet werden kann.

Insbesondere erweist sich als vorteilhaft, daß die Ruhestromaufnahme des Erfindungsgegenstands bei fehlender Steuergerätemasse (SM) oder bei einem positiven Potential an der Steuergerätemasse (SM) auf ein Minimum reduziert wird. Die Ruhestromaufnahme ist hier kleiner gleich 1 mA.

## Ansprüche

1. Steuergerät mit einer Schaltungsanordnung zum Schutz des Steuergeräts bei Unterbrechung der Steuergerätemasse, insbesondere in Kraftfahrzeugen, mit einem MOS-Feldeffekttransistor in einem Ausgangskreis, mit einem Steuereingang, der mit der Gate-Elektrode des MOS-Feldeffekttransistors verbunden ist, um diesen in den leitenden oder sperrenden Zustand zu schalten, und mit einem bipolaren Transistor, dessen Kollektor mit der Gate-Elektrode, dessen Emitter mit der Source-Elektrode und dessen Basis über einen ersten Widerstand mit der Drain-Elektrode des MOS-Feldeffekttransistors verbunden ist, dadurch gekennzeichnet, daß mindestens eine Last (L) zwischen dem negativen Pol einer Spannungsquelle (B) und der Source-Elektrode (S) angeordnet ist, die über die Drain-Elektrode (D) mit dem positiven Pol der Spannungsquelle (B) elektrisch leitend verbindbar ist und daß ein zweiter Widerstand (R2) zum einen über einen Verbindungspunkt (V) mit dem ersten Widerstand (R1) und mit der Steuergerätemasse (SM) und zum anderen mit der Basis des bipolaren Transistors (T2) verbunden ist.

2. Steuergerät nach Anspruch 1, dadurch gekennzeichnet, daß die Anode einer ersten Zenerdiode (Z1) mit der Source-Elektrode (S) des MOS-Feldeffekttransistors (T1) und die Kathode der ersten Zenerdiode (Z1) mit der Basis des bipolaren Transistors (T2) verbunden ist.

3. Steuergerät nach Anspruch 1, dadurch gekennzeichnet, daß die Anode einer zweiten Zenerdiode (Z2) mit der Source-Elektrode (S) und die Kathode der zweiten Zenerdiode (Z2) mit der Gate-Elektrode (G) des MOS-Feldeffekttransistors (T1) verbunden ist.

4. Steuergerät nach Anspruch 1, dadurch gekennzeichnet, daß die Source-Elektrode (S) über einen dritten Widerstand (R3) mit der Gate-Elektrode (G) des MOS-Feldeffekttransistors (T1) verbunden ist.

5. Steuergerät nach Anspruch 1, dadurch gekennzeichnet, daß die Drain-Elektrode (D) über eine bidirektionale Doppel-Zenerdiode (Z3) mit der Source-Elektrode (S) des MOS-Feldeffekttransistors (T1) verbunden ist.

6. Steuergerät nach Anspruch 1, dadurch gekennzeichnet, daß die Drain-Elektrode (D) und der positive Pol der Spannungsquelle (B) über einen Kondensator (C) mit dem negativen Pol der Spannungsquelle (B) verbunden ist.

7. Steuergerät nach Anspruch 1, dadurch gekennzeichnet, daß die Steuergerätemasse (SM) über einen externen Schalter oder eine externe Schaltvorrichtung auf ein positives Potential oder potentialfrei schaltbar ist.

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 239 862 (SIEMENS)<br>* Spalte 2, Zeile 5 - Spalte 3, Zeile 17; Figur * <br>--- | 1,3,4 | H 03 K 17/08<br>H 02 H 11/00 |
| Y | DE-A-3 034 927 (SIEMENS)<br>* Seite 4, Zeile 7 - Seite 5, Zeile 23; Figur * <br>--- | 1,3,4 | |
| A | DE-A-3 325 361 (GENERAL ELECTRIC CO.)<br>* Seite 6, letzter Absatz - Seite 7, Zeile 1; Figur * <br>--- | 5 | |
| A | US-A-4 454 430 (MILLER)<br>* Spalte 4, Zeile 44 - Spalte 5, Zeile 5; Figur 1 * <br>----- | 6 | |

### RECHERCHIERTE SACHGEBIETE (Int. Cl.5)

H 03 K
H 02 H

Der vorliegende Recherchenbericht wurde für alle Patentansprüche erstellt

| Recherchenort | Abschlußdatum der Recherche | Prüfer |
|---|---|---|
| DEN HAAG | 24-11-1989 | CANTARELLI R.J.H. |